## Europäisches Patentamt

## European Patent Office

## Office européen des brevets

(19)

(11) Veröffentlichungsnummer: **0 086 905**
**B1**

(12) **EUROPÄISCHE PATENTSCHRIFT**

(45) Veröffentlichungstag der Patentschrift:
08.04.87

(51) Int. Cl.⁴: **G 06 F 11/20**

(21) Anmeldenummer: **82200197.0**

(22) Anmeldetag: **18.02.82**

(54) Speichersystem mit einer integrierten Matrix aus nichtflüchtigen, umprogrammierbaren Speicherzellen.

(43) Veröffentlichungstag der Anmeldung:
**31.08.83 Patentblatt 83/35**

(45) Bekanntmachung des Hinweises auf die Patenterteilung:
**08.04.87 Patentblatt 87/15**

(84) Benannte Vertragsstaaten:
**DE FR GB IT NL**

(56) Entgegenhaltungen:
US-A-3 331 058
US-A-3 422 402
US-A-3 665 426
US-A-3 934 227

IBM TECHNICAL DISCLOSURE BULLETIN, Band 12, Nr. 9, Februar 1970, Seiten 1441-1442, New York (USA);
IBM TECHNICAL DISCLOSURE BULLETIN, Band 13, Nr. 8, Januar 1971, Seite 2380, New York (USA);
G. H. SMITH et al.: "Substitute memory location assignment for faulty locations"
L. J. DUNLOP: "Redundancy technique for bad bit replacement"
IEEE Journal of Solid State Circuits, Oct. 1978,Vol. SC-13, Nr. 5, Seiten 698-703

(73) Patentinhaber: **Deutsche ITT Industries GmbH, Hans- Bunte- Strasse 19 Postfach 840, D-7800 Freiburg (DE)**
(84) Benannte Vertragsstaaten: **DE**

(73) Patentinhaber: **ITT INDUSTRIES INC., 320 Park Avenue, New York, NY 10022 (US)**
(84) Benannte Vertragsstaaten: **FR GB IT NL**

(72) Erfinder: **Giebel, Burkhard, Dipl.- Ing., Asenweg 15, D-8000 München 83 (DE)**
Erfinder: **Fischer, Thomas, Dr., In Der Breite 44, D-7801 Umkirch (DE)**

(74) Vertreter: **Morstadt, Volker, Dipl.- Ing., c/o Deutsche ITT Industries GmbH Patent/Lizenzabteilung Postfach 840 Hans- Bunte- Strasse 19, D-7800 Freiburg/Brsg. (DE)**

## Beschreibung

Die Erfindung betrifft ein Speichersystem mit einer integrierten Matrix aus nichtflüchtigen, umprogrammierbaren Speicherzellen, von der ein Teilbezirk als Ersatzspeicher dient oder wobei ein Ersatzspeicher zusätzlich vorgesehen ist, dessen Zeilen oder Spalten defekte Matrixzeilen oder -Spalten ersetzen, deren Adressen nach dem Testen der Matrix sowohl in Korrekturregistern aus statischen, flüchtigen Speicherzellen deren Ausgänge beim betriebsmäßigen Auftreten dieser Adressen die entsprechenden Zeilen oder Spalten des Ersatzspeichers unter Blockierung der defekten Matrixzeilen oder -spalten aktivieren, als auch in einem Festwertspeicher gespeichert werden, vergleiche den Oberbegriff des Anspruchs 1.

Die Erfindung beschäftigt sich somit mit den sogenannten redundanten Speichern, bei denen mehr Speicherzellen als benötigt vorgesehen werden, so daß nicht brauchbar produzierte, also defekte, Speicherzellen durch die überzähligen und somit redundanten Speicherzellen ersetzt werden können. Die Erfindung geht von einem Stand der Technik aus, wie er in der Zeitschrift "IEEE Journal of Solid-State Circuits", Oktober 1978, Seiten 698 bis 703, insbesondere Seite 699, linke Spalte, zu finden ist. Von den dort angegebenen drei Möglichkeiten zur Speicherung der Adressen der defekten Speicherzellen ist im Rahmen der Erfindung nur die dort als erste angegebene, nämlich die mittels statischen, flüchtigen Speicherzellen (dort als "electrically alterable latches" bezeichnet) von Interesse. In Zusammenhang mit dieser Speicherungsvariante ist angegeben, daß wegen der Flüchtigkeit dieser Art von Speicherung die Adressen der defekten Speicherzellen zusätzlich noch in einem Festwertspeicher enthalten sein müssen, wofür in der genannten Literaturstelle beispielsweise ein "Disk", also eine nach dem Magnetaufzeichnungsverfahren funktionierende Speicherplatte vorgesehen werden kann.

Im Hinblick auf die integrierte Herstellung derartiger Speichermatrizen stellt jedoch die Verwendung von Speicherplatten eine mit der Halbleitertechnik nicht kompatible Technik dar. Es besteht daher grundsätzlich die Forderung, daß die gesamten Funktionen eines derartigen redundanten Speichers mit der Technik integrierter Halbleiterschaltungen zu realisieren ist. Es verbietet sich daher für eine möglichst umfassende Integrierung die Anwendung von Magnetplatten zur festen Speicherung der Adressen von defekten Speicherzellen.

Die im Anspruch gekennzeichnete Erfindung löst somit die Aufgabe, eine redundante Speichermatrix entsprechend dem Oberbegriff des Anspruchs 1 unter ausschließlicher Anwendung von in der Halbleitertechnkk üblichen Mitteln auszubilden, wobei Spezialtechniken, wie zum Beispiel die in der genannten Druckschrift angegebene Verwendung von durchbrennbaren Widerständen oder mittels Lasern zu trimmenden Bauelementen als wiederum mit der Integrierungs-Standard-Technologie nur unter erhöhtem Aufwand kompatible Sonderverfahren ausgeschlossen sein sollen. Derartige Spezialverfahren erfordern nämlich einen zusätzlichen und beträchtlichen apparativen Aufwand und bringen insbesondere bei der Realisierung derartiger Speichermatrizen auf möglichst kleiner Fläche, also möglichst mit geringen Leitbahnbreiten und- abständen, eine Reihe von Schwierigkeiten mit sich.

Zum Stand der Technik ist noch auf folgende Fundstellen zu verweisen. Aus "IBM Techn. Discl. Bull.", Febr. 1970, Seiten 1441/42 ist es an sich bekannt, die Adressen defekter Stellen eines Speichers in einem Indexteil desselben Speichers abzulegen und die defekten Stellen durch intakte zu ersetzen. Die US-Patentschriften 33 31 058, 34 22 402 und 39 34 227 beschäftigen sich ebenfalls mit redundanten und somit reparier- bzw. ersatzfähigen Speichersystemen.

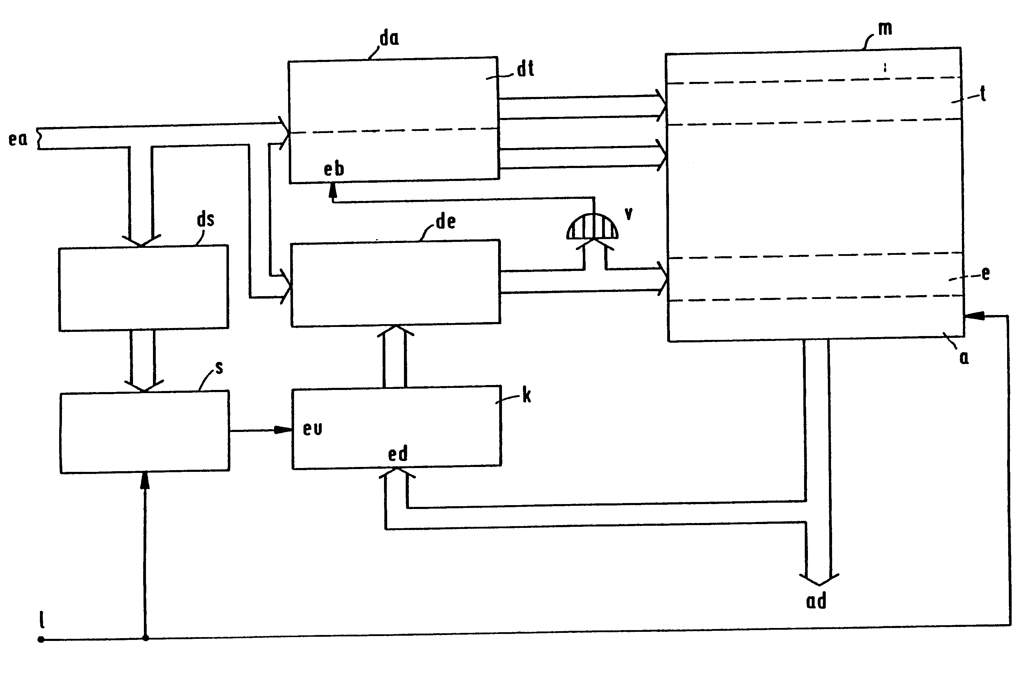

In der Figur der Zeichnung ist ein schematisches Blockschaltbild der erfindungsgemäßen Matrix aus nichtflüchtigen, umprogrammierbaren Speicheizellen zur näheren Erläuterung gezeigt. Die Matrix m besteht wie allgemein üblich aus in Spalten und Zeilen angeordneten Speicherzellen, wobei für die Figur vorausgesetzt ist, daß die Informationsspeicherung und der Zugriff zu dieser Information im wesentlichen zeilenweise erfolgt. Der im unteren Teil der Matrix m gestrichelt gezeichnete Teilbezirk dient als Ersatzspeicher e, dessen Zeilen defekte Matrixzeilen eisetzen. Im oberen Teil der Matrix m ist ferner der Matrixteil t aus intakten Matrixzeilen gezeigt, wobei dieser Matrixteil bei der Konzeption der Matrix m und deren Herstellung von vornherein in dieser Position festgelegt ist. Schließlich sind als unterster Teil der Matrix m die Datenausgänge a besonders gekennzeichnet, die im allgemeinen so konzipiert sind, daß mittels des den Lesebetrieb charakterisierenden Signals 1 die gespeicherten Daten an den Datenausgang ad durchgeschaltet werden.

Die einzelnen Zeilen der Matrix m werden von den an den Adreßeingang ea angelegten Adressen dieser Zeilen über den Adreßdecoder da angesteuert, von dem der Teildecoder dt für die Adressen der Zeilen im festgelegten intakten Matrixteil t besonders gezeichnet ist. Dem Ersatzspeichere ist der Ersatzdecoder de zugeordnet, dessen Eingang ebenfalls mit dem Adreßeingang ea verbunden ist.

Der Dateneingang ed der Korrekturregister k ist mit dem Datenausgang a der Matrix m verbunden, und sein Datenübernahmeeingang eu liegt am Ausgang der Steuerstufe s. Dieser sind zwei Arten von Eingangssignalen zugeführt, nämlich zum einen das den Lesebetrieb charakterisierende Signal 1 und zum anderen die Ausgangssignale eines Steuerdecoders ds, der auf dieselben Adressen anspricht wie der Teildecoder dt des Adreßdecoders da.

Schließlich sind die Ausgangsleitungen des Ersatzdecoders de über das Vielfach-ODER-Gatter mit dem Blockiereingang eb des Adreßdecoders da verbunden, wodurch in bekannter Weise bei betriebsmäßiger Auswahl eines Ersatzdecoders de die entsprechenden Ausgänge des Adreßdecoders de unter Blockierung der defekten Matrixzeilen deaktiviert werden.

Bei Betrieb der integrierten Matrix m nach der Erfindung wird am Ende jedes Einschaltvorgangs der Betriebsspannung oder, wenn während des Betriebs eine Abweichung vom Sollwert der Betriebsspannung auftritt, am Ende dieser Abweichung während eines Normierzyklus die Matrix m nur mit den Adiessen des festgelegten Matrixteils t gespeist. Dadurch gibt die Steuerstufe s ein Signal ab, das über den Datenübernahmeeingang eu der Korrekturregister diese zur Aufnahme von Daten öffnet, so daß die dann am Datenausgang a der Matrix m auftretenden und aus dem festgelegten Matrixteil t ausgelesenen adressen der defekten Zeilen in die Korrekturregister eingelesen werden. Die Korrekturiegister k sind somit für den üblichen Speicherbetrieb dei Matrix m mit den Adressen der defekten Zeilen geladen, und die Matrix m arbeitet in dei bekannten Weise.

Bei der Erfindung ist somit kein halbleitertechnikinkompatibler Festwertspeicher erforderlich, sondern es wird vielmehr ein bestimmter festgelegter Matrixteil der integrierten Matrix m aus nichtflüchtigen, umprogrammierbaren Speicherzellen als derartiger Festwertspeicher benutzt. Der Hauptvorteil dei Erfindung ergibt sich somit unmittelbar aus der Aufgabenlösung. Ferner ist es ohne weiteres möglich, die Speichermatrix in ein umfangreicheres Gesamtsystem einzubeziehen, beispielsweise in einen Mikroprozessor, wobei dann beispielsweise dessen Reset-Routine dazu herangezogen werden kann, den geschilderten Normierzyklus durch Anlegen der Adressen des festgelegten Matrixteils t auszuführen.

Obwohl die Beschreibung der Erfindung im wesentlichen nur das zeilenweise Lesen und Schreiben der Matrix erwähnt, ist es für den Fachmann selbstverständlich, daß er im Bedarfsfall den Grundgedanken der Erfindung auch realisieren kann, wenn anstatt zeilenweiser spaltenweise Informationsverarbeitung vorgesehen werden muß.

Als Speicherzellen eignen sich insbesondere die verschiedenen bekannten Arten von sogenannten Floating-Gate-Speicherzellen, vergleiche beispielsweise die Zeitschrift "Electronics", 28.2.1980, Seiten 113 bis 117 und die Offenlegungsschrift DE-A- 30 07 892.

**Patentansprüche**

1. Speichersystem mit einer integrierten Matrix (m) aus nichtflüchtigen, umprogrammierbaren Speicherzellen, von der ein Teilbezirk als Ersatzspeicher (e) dient oder wobei ein Ersatzspeicher zusätzlich vorgesehen ist, dessen Zeilen oder Spalten defekte Matrixzeilen oder - Spalten ersetzen, deren Adressen nach dem Testen der Matrix sowohl in Korrekturregistern (k) aus statischen, flüchtigen Speicherzellen, deren Ausgänge beim betriebsmäuigen Auftreten dieser Adressen die entsprechenden Zeilen oder Spalten des Eisatzspeichers (e) unter Blockierung der defekten Matrixzeilen oder - Spalten aktivieren, als auch in einem Festwertspeicher gespeichert werden, gekennzeichnet durch folgende Merkmale:
- als Festwertspeicher für die Adressen der defekten Matrixzeilen oder - Spalten dient ein zeilen - oder spaltenweise festgelegter, intakter Teil (t) der Matrix (m),
- die Datenausgänge (a) der Matrix (m) sind mit den Dateneingängen (ed) der Korrekturregister (k) verbunden,
- der Datenübernahmeeingang (eu) der Korrekturregister (k) liegt am Ausgang einer Steuerstufe (s), die das Korrekturregister zur Datenaufnahme frei gibt, wobei einem ersten Eingang derstellen ein den Lesebetrieb der Matrix charakterisierendes Signal (1) zugeführt ist und ein zweiter Eingang derselben mit dem Adreßeingang (ea) der Matrix (m) über einen Steuerdecoder (ds) für die Adressen des festgelegten Matrixteils (t) verbunden ist, und
- eine Betriebsschaltung, die am Ende jedes Einschaltvorganges der Betriebsspannung oder am Ende jeder Abweichung von deren Sollwert während eines Normierzyklus die Matrix (m) nur mit den Adressen des festgelegten Matrixteils (t) speist, wobei die aus diesem Matrixteil gelesenen Adressen in die Korrekturregister eingespeichert werden.

**Claims**

1. Storage system comprising an integrated matrix (m) of non-volatile, reprogrammable storage cells, one subarea of the matrix (m) serving as a redundant storage (e) or a redundant storage being provided as an additional device whose rows or columns replace faulty matrix rows or columns whose addresses, after the matrix has been tested, are stored both in correction resisters (k) consisting of static, volatile storage cells whose outputs, on the occurrence of these addresses during operation. activate the corresponding rows or columns of the redundant storage (e) while blocking the faulty matrix rows or columns, and in a read-only memory,
characterized by the following features:
- As the read-only memory for the addresses of the faulty matrix rows or columns, a predetermined, intact portion (t) of the matrix (m) is used;

- the data outputs (a) of the matrix (m) are connected to the data inputs (ed) of the correction registers (k);

- the enable inputs (en) of the correction resisters (k) are connected to the output of a control stage (s) which enables the correction registers to receive data, with a first input of the control stage (s) supplied with a signal (1) characterizing the read mode of the matrix, and a second input of the control stage (s) connected to the address input (ea) of the matrix (m) via a control decoder (ds) for the addresses of the predetermined matrix portion (t), and

- a circuit which, at the end of each turn-on process of the supply voltage or at the end of any deviation from the nominal value of the supply voltage, feeds the matrix (m) only with the addresses of the predetermined matrix portion (t) during a scaling cycle, with the addresses read from this matrix portion being transferred into the correction registers.

## Revendications

Système de mémoire comportant une matrice intégrée (m) de cellules de mémoire reprogrammables non volatiles dont une zone sert de mémoire redondante (e) ou dans laquelle une mémoire redondante est additionnellement prévue, dont les rangées ou les colonnes remplacent les rangées ou les colonnes défectueuses de la mémoire, les adresses de celles-ci, à la suite du test de la matrice, étant enregistrées aussi bien dans des registres correction (k) consistant en cellules de mémoire volatiles statiques, dont les sorties, lorsque surviennent ces adresses dans le cours de l'exploitation, activent les rangées ou les colonnes correspondantes de la mémoire redondante (e), tout en bloquant les rangées défectueuses de la matrice, que dans une mémoire morte, caractérisé en ce que:

- la mémoire morte pour les adresses des rangées, ou des colonnes défectueuses de la matrice est une partie de matrice intacte (t) fixe, utilisée par rangée, ou par colonne,

- les sorties de données (a) de la matrice (m) sont connectées aux entrées de données des registres de correction (k),

- l'entrée de transfert de données (eu) des registres de correction (k) est connectée à la sortie d'un étage de commande (s), lequel active les registres de correction lors d'un transfert de données, une première entrée de celui-ci recevant un signal (I) caractérisant une opération de lecture de la matrice et une seconde entrée de celui-ci étant connectée à l'entrée d'adresse (ea) de la matrice (m) par l'intermédiaire d'un décodeur de commande (ds) pour les adresses de ladite partie de mémoire fixe (t), et

- à la fin de chaque processus détablissement de la tension d'alimentation, ou à la fin de chaque déviation de cette tension par rapport à sa valeur nominale, au cours d'un cycle de normalisation, la matrice (m) est seulement alimentée par les adresses de ladite partie de matrice fixe (t), de sorte que les adresses lues dans cette partie de matrice sont enregistrées dans les registres de correction.